# EUROPEAN PATENT APPLICATION

(11) **EP 3 185 277 A1**
(43) Date of publication of application: **28.06.2017**
(21) Application number: 15202713.2
(22) Date of filing: 24.12.2015
(51) Int. Cl.: H01L 21/02, C09K 11/08, C30B 29/48

(54) **METHOD FOR ASSEMBLING SEMICONDUCTOR NANOCRYSTALS**

(71) Applicant: Universiteit van Amsterdam, 1012 WX Amsterdam (NL)
(72) Inventor: MARINO, Emanuele, 1098 XH AMSTERDAM (NL); KODGER, Thomas Edward, 1098 XH AMSTERDAM (NL); SCHALL, Peter, 1098 XH AMSTERDAM (NL)
(74) Representative: De Vries & Metman

(57) **Abstract**

A method is described for for assembling semiconductor nanocrystals comprising:
- providing a binary system comprising semiconductor nanocrystals with an effective particle diameter of at most 20 nm, a first solvent, and a second solvent,
- the system having
* a Ta, which is the aggregation temperature of the system,
* a Ts, which is the solvent separation temperature of the system,
* an aggregation temperature range, which is the range between Ta and Ts with Ta being included and Ts not being included,
* a homogeneous temperature range which is below Ta when Ta is lower than Ts and which is above Ta when Ta is higher than Ts,
* a heterogeneous temperature range which is above Ts when Ta is lower than Ts and below Ts when Ta is higher than Ts,

and,
- bringing the temperature of the binary system from a value in the homogeneous temperature range to a value in the aggregation temperature range, thereby causing formation of an aggregate of said semiconductor nanocrystals.

## Description

### Field of the invention

The present invention pertains to a method for assembling semiconductor nanocrystals to form aggregates. The invention also pertains to aggregates that can be obtained using the method according to the invention, to the use of these aggregates in semiconductor devices, and to semiconductor devices comprising such aggregates.

### Background of the invention

Semiconductor nanocrystals, also indicated as quantum dots (QDs), offer the unique possibility for controlling optical and electronic properties by simply tuning their size. The act of confining electronic excitations within linear dimensions smaller than the bulk exciton Bohr radius gives rise to quantum effects leading to the discretization of the band structure and to a size-dependent band gap. While it has been possible to characterize the properties of single (non-interacting) dots, currently considerable effort is being made in the pursuit of well-ordered QD superstructures. Inter-dot coupling would improve electronic transport that is needed for electronic and opto-electronic devices, e.g. QD-based solar cells, power conversion efficiency values in such devices can be improved.

Efficient charge transport though quantum dot super structures requires the formation of delocalized molecular orbital-like states that extend over multiple dots. The effect ultimately brings to the formation of super-band structures (mini-bands) in an analogous way to the transition from isolated atoms to atoms in a lattice. This mechanism enables charges to travel through multiple quantum dots by efficient coherent resonant tunneling processes. This regime of transport however requires careful assembly of quantum dot superstructures. Combining precise quantum dot synthesis techniques with assembly of quantum dots into superstructures would yield bottom-up tailored material properties, while showing the beneficial transport characteristics of bulk semiconductors.

Currently a number of techniques exist for forming quantum dots structures. Substantially two dimensional quantum dots structures may be formed using known assembly methods such as drop-casting, spin coating, and interfacial driven assembly techniques. For example, Baumgardner et al. describe in their article "Confined-but-Connected Quantum Solids via Controlled Ligand Displacement", Nano Lett., 2013, 13 (7), pp 3225-3231, the formation of a one-layer (monolayer) two-dimensional arrangement of quantum dots using a self-assembly technique. A monolayer 2D QD structure is formed on a substrate by placing a PbSe QD dispersion in toluene on top of a volume of oleic acid. After evaporation of the toluene, a one-layer thick two-dimensional arrangement of quantum dots is formed. Subsequent heating of the arrangement leads to fusion of the quantum dots thereby forming a 2D network of electrically connected quantum dots.

Although these techniques allow formation of low dimensional (typically a monolayer) 2D arrangements of QDs, they are not suitable for forming 3D (bulk) QD structures wherein the dimensions of the aggregate in each direction is larger than the dimensions of the QDs. In particular, there is no scalable fabrication technique available for controllably forming 3D (bulk) aggregate QD structures that are needed in the fabrication of quantum dot superstructures for electronic and optoelectronic devices.

Hence, there is need in the art for methods and processes for forming quantum dot aggregates wherein the distance between the QD in the aggregate can be controlled in the nm range. In particular, there is a need in the art for forming 3D quantum dot aggregates wherein the distance between a substantial part of neighboring quantum dots in the aggregate is such that delocalized molecular orbital-like states may be formed extending over multiple dots. This can be seen by a shift in the photoluminescence spectrum of the aggregate to the red as compared to the photoluminescence spectrum of dots in their unaggregated state. The formation of such delocalized states require assembly of 3D quantum dot structures wherein the distance between neighboring quantum dots is at most 10 nm, preferably smaller than 5 nm, more preferably smaller than 2 nm, more in particular below 1 nm, specifically below 0.5 nm.

A further issue in the manufacture of quantum dot aggregates is the following. Different types of quantum dots may have different chemical compositions and different surface properties, e.g., caused by the presence of different types of ligands. The aggregation processes known in the art are generally tailored to the chemistry and surface properties of the specific type of quantum dot. This means that the selection of a different type of quantum dot may necessitate the development of a new method for assembling the particles to form aggregates. There is thus need in the art for a method which is generally applicable in the aggregation of quantum dots, with only a limited dependence on the chemical composition and surface properties of the quantum dots.

Therefore, there is need in the art for up-scalable and general methods and processes for forming 3D quantum dot structures in a controllable and reproducible manner, which does not require the use of expensive apparatus. It is further desired to be able to integrate the manufacture of the 3D quantum dot structures in the manufacturing process of the device itself.

### Summary of the invention

It is an objective of the invention to reduce or eliminate at least one of the drawbacks known in the prior art.

In an aspect the invention may relate to a method for assembling semiconductor nanocrystals to form an aggregate comprising:
- providing a binary system comprising semiconductor nanocrystals with an effective particle diameter of at most 20 nm, a first solvent, and a second solvent,
- the system having
   * a Ta, which is the aggregation temperature of the system,
   * a Ts, which is the solvent separation temperature of the system,
   * an aggregation temperature range, which is the range between Ta and Ts with Ta being included and Ts not being included,
   * a homogeneous temperature range which is below Ta when Ta is lower than Ts and which is above Ta when Ta is higher than Ts,
   * a heterogeneous temperature range which is above Ts when Ta is lower than Ts and below Ts when Ta is higher than Ts, and,
- bringing the temperature of the binary system from a value in the homogeneous temperature range to a value in the aggregation temperature range, thereby causing formation of an aggregate of said semiconductor nanocrystals.

It has been found that the method according to the invention makes it possible to obtain aggregates with suitable properties. Further, the process can be carried out in a stable and reproducible manner, and can be applied using simple apparatus. It can be incorporated in-line into a device manufacturing process. Further advantages of the present invention and specific embodiments thereof will become apparent from the further specification.

In a further aspect the invention may relate to a three-dimensional aggregate of semiconductor nanocrystals with an effective particle diameter of at most 20 nm, which aggregate has a size in all dimensions of at least 5 times the diameter of the nanocrystals, the distance between at least some of the neighboring nanocrystals in the aggregate being at most 10 nm, the aggregate showing a photoluminescence spectrum which shows a shift to the red as compared to the photoluminescence spectrum of the semiconductor nanocrystals in their unaggregated state.
In further aspects the invention may relate to a substrate provided with a three-dimensional aggregate as described herein, to a semiconductor device comprising a three-dimensional aggregate as described herein, and to the use of a three-dimensional aggregate as described herein in a semiconductor device.

The invention will be further illustrated with reference to the attached drawings, which schematically will show embodiments according to the invention. It will be understood that the invention is not in any way restricted to these specific embodiments.

### Brief description of the drawings

**Fig. 1A** shows the phase separation temperature curve of a water/3MP binary system comprising semiconductor quantum dots.
**Fig. 1B** shows the phase separation temperature curve of a hexane/nitrobenzene binary system comprising semiconductor quantum dots.
**Fig. 2A** shows a graph of the Debye screening length as a function of the sodium chloride content of the binary mixture.
**Fig. 2B** shows a phase diagram for the water/3MP binary system comprising semiconductor quantum dots as a function of NaCl salt content.
**Fig. 3** shows a scanning electron microscope (SEM) picture of aggregates obtained by methods according to the invention.
**Fig. 4** and **5** show dynamic light scattering data of samples obtained by methods according to the invention.
**Fig. 6** shows photoluminescence spectra of nanocrystals obtained by methods according to the invention.
**Fig. 7** shows a schematic the formation of new electronic states due to inter-dot coupling.
**Fig. 8** shows a schematic representation of the experimental setup of Example 4.

### Detailed description

An important feature of the present invention is the controlled assembly of quantum dot superstructures using a binary system comprising a first solvent and a second solvent.

In a binary system, the miscibility of the solvents depends on temperature, with the system being homogeneous at certain temperatures and heterogeneous at other temperatures. There are two types of binary systems, namely, a binary system which is homogeneous at lower temperatures and heterogeneous above a phase separation temperature (also indicated herein as TIS system which stands for Temperature Increase Separation system), and a binary system which is heterogeneous at lower temperatures and homogeneous above a phase separation temperature (also indicated herein as TDS system which stands for Temperature Decrease Separation system).

The temperature at which phase separation occurs will in the following also be indicated as the phase separation temperature Ts. As will be discussed in more detail below, it has been found that when starting out with a homogeneous system and changing the temperature to a value closer to Ts, assembly of the nanocrystals into aggregates will start to take place before Ts is reached. The temperature at which aggregation starts to take place will in the present specification also be indicated as aggregation temperature Ta. Therewith, the following temperature ranges can be identified:
* an aggregation temperature range, which is the range between Ta and Ts with Ta being included and Ts not being included,
* a homogeneous temperature range which is below Ta when Ta is lower than Ts and which is above Ta when Ta is higher than Ts,
* a heterogeneous temperature range which is above Ts when Ta is lower than Ts and below Ts when Ta is higher than Ts.

Thus, in a TIS system comprising nanocrystals, the system is homogeneous at lower temperatures (below Ta). In this temperature range, the interaction of the two types of solvents allows the nanocrystals to be present in the form of a homogeneous colloidal dispersion. When the temperature of the system is increased, a value Ta is reached, and the nanocrystals will start to assemble into an aggregate. If the temperature of the system would be increased to an even higher value, above Ts, the two solvent components will separate to form two coexisting liquids in a heterogeneous system. In the heterogeneous binary system, the nanocrystals will preferentially and homogeneously disperse in one of the two phases, depending on the surface chemistry properties of the particles.

Conversely, in a TDS system comprising nanocrystals, the system is homogeneous at higher temperatures (above Ta). When the temperature of the system is decreased, a value Ta is reached, and the nanocrystals will start to aggregate. If the temperature of the system would be decreased to an even lower value, below Ts, the two solvent components will separate to form two coexisting liquids in a heterogeneous system.

Thus, in one embodiment of the present invention the binary system is a TIS system. In this embodiment, the invention is directed to a method for assembling semiconductor nanocrystals comprising:
- providing a binary system comprising semiconductor nanocrystals with an effective particle diameter of at most 20 nm, a first solvent, and a second solvent,
- the system having
   * a Ts, which is the solvent separation temperature of the system,
   * a Ta, which is the aggregation temperature of the system, Ta being below Ts,
   * an aggregation temperature range, which is the range between Ta and Ts with Ta being included and Ts not being included,
   * a homogeneous temperature range which is below Ta,
   * a heterogeneous temperature range which is above Ts, and,
- bringing the temperature of the binary system from a value in the homogeneous temperature range to a value in the aggregation temperature range, thereby causing formation of an aggregate of said semiconductor nanocrystals.

In another embodiment of the present invention the binary system is a TDS system. In this embodiment, the invention is directed to a method for assembling semiconductor nanocrystals comprising:
- providing a binary system comprising semiconductor nanocrystals with an effective particle diameter of at most 20 nm, a first solvent, and a second solvent,
- the system having
   * a Ts, which is the solvent separation temperature of the system,
   * a Ta, which is the aggregation temperature of the system, which Ta is above Ts,
   * an aggregation temperature range, which is the range between Ta and Ts with Ta being included and Ts not being included,
   * a homogeneous temperature range which is above Ta,
   * a heterogeneous temperature range which is below Ts, and,
- bringing the temperature of the binary system from a value in the homogeneous temperature range to a value in the aggregation temperature range, thereby causing formation of an aggregate of said semiconductor nanocrystals.
Both TIS systems and TDS systems are suitable for use in the present invention. TIS systems are considered preferred at this point in time.

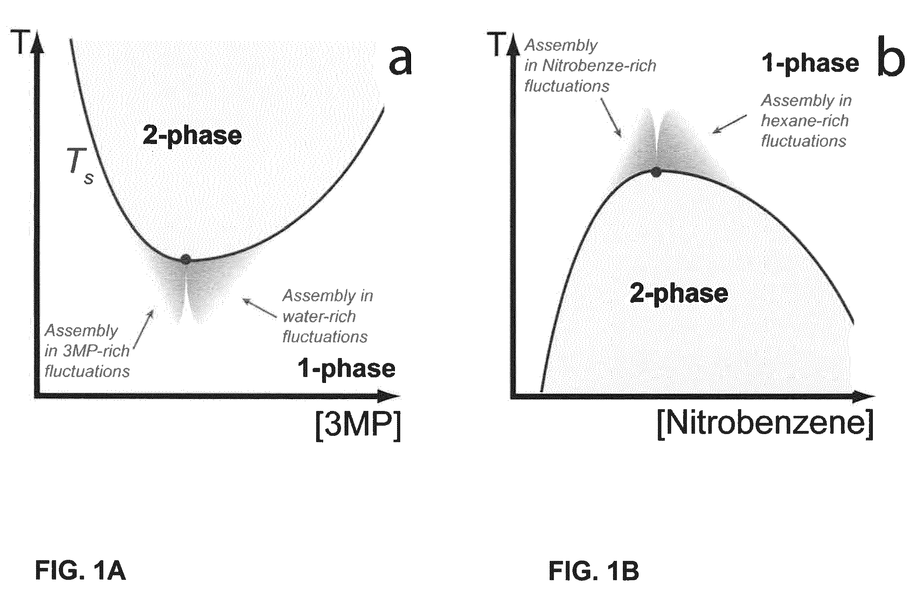

**Fig. 1A** shows the phase separation temperature curve for a water/3-methyl pyridine (3MP) binary system comprising semiconductor quantum dots. **Fig. 1A** shows the phase separation temperature curve as a function of temperature and concentration of 3-methyl pyridine. The water/3MP system is a TIS system which is homogeneous below Ta, and heterogeneous above Ts.

**Fig. 1B** shows the phase separation temperature curve for a hexane/nitrobenzene binary system comprising semiconductor quantum dots. **Fig. 1B** shows the phase separation temperature curve as a function of temperature and concentration of nitrobenzene. The hexane/nitrobenzene system is a TDS system which is homogeneous above Ta, and heterogeneous below Ts.

In **Fig. 1A** the Ts curve shows a minimum at a specific composition. In **Fig. 1B** the Ts curve shows a maximum. The extreme (minimum or maximum) point in the phase separation temperature curve may be referred to as the critical point. The concentration of one of the solvents of the binary system at which the critical point resides may be referred to as critical concentration. Similarly, the temperature at which the critical point resides may be referred to as the critical temperature.

Where a binary system comprises nanocrystals, it has been found that in solvent concentration ranges surrounding the critical concentration the nanocrystals show a specific aggregation behavior when the temperature of a homogeneous system is brought closer to Ts. In this concentration range, an aggregation temperature Ta can be defined.

In the process of the present invention, the first step is providing a binary system comprising semiconductor nanocrystals with an effective particle diameter of at most 20 nm, a first solvent, and a second solvent.

The system is in the homogeneous temperature range, that is, at a temperature below Ta when Ta is lower than Ts (in a TIS system) and which is above Ta when Ta is higher than Ts (in a TDS system). As indicated above, Ta is the temperature at which aggregation occurs, which can be determined via dynamic light scattering, which determines the size of the particles present in the system. If the size of the particles in the system, as can be seen from a dynamic light scattering profile, is constant over time, e.g., for a period of 24 hours, the system is in the homogeneous temperature range (i.e. below Ta when Ta is lower than Ts and above Ta when Ta is higher than Ts). If the dynamic light scattering profile of the system is not constant over time, that is, if the profiles of a freshly prepared system and a system which has been stored for 24 hours are not the same, the system is in the aggregation temperature range (i.e. in the range between Ta and Ts with Ta being included and Ts not being included). It is within the scope of the skilled person to determine Ta by preparing samples at different temperatures, and comparing the dynamic light scattering profiles of fresh systems with those of the same system after storing for 24 hours at the specific temperature.

Then, the temperature of the binary system is brought from a value in the homogeneous temperature range to a value in the aggregation temperature range, thereby causing formation of an aggregate of said semiconductor nanocrystals. The not-included upper limit of the aggregation temperature range Ts is the solvent separation temperature, that is, the temperature at which the first and the second solvent demix to form two coexisting liquids. Ts can be determined by slowly (e.g. 0.1 °C/minute) changing the temperature of the sample from a value within the aggregation temperature range to a value within the heterogeneous temperature range, and monitoring the opalescence/turbidity of the sample. The occurrence of opalescence/turbidity is due to the onset of phase separation due to the formation of light-scattering droplets.

In the present invention the change of the temperature from a value in the homogeneous temperature range to a value in the aggregation temperature range results in a controlled assembly of the particles into aggregates.

Not wishing to be bound by theory, the mechanism underlying the present invention is believed to be as follows. It has been found that in a specific concentration region around the critical concentration and near the phase separation temperature the solvent mixture exhibits long range density compositional fluctuations, which lead to the aggregation of the nanocrystals occurring below the phase separation temperature. In **Fig. 1A** and **Fig 1B** these ranges are indicated as shaded grey areas surrounding the critical point.

For the TIS system in **Fig. 1A****,** when the temperature is below Ta, the system is homogeneous, and the semiconductor nanoparticles are homogeneously dispersed. When the temperature in the homogeneous phase is increased to a value below but close to the phase separation temperature, solvent-mediated attractive interactions arise between suspended nanoparticles. A particular well-controlled and universal interaction occurs close to the critical point. As indicated above, the critical point is the extreme (in **Fig. 1A** the minimum) of the phase separation curve in a graph in which the separation temperature is expressed as a function of the solvent composition. It has been found that when the mixture is close to the critical point both as regards temperature and as regards concentration, solvent concentration fluctuations become long range, and their confinement between particle surfaces gives rise to so-called critical Casimir forces.

In analogy to the quantum mechanical Casimir effect, in which confinement of zero-point fluctuations of the electromagnetic field between two conductive walls gives rise to an attractive force, the confinement of solvent fluctuations in the liquid gap between immersed surfaces gives rise to attractive critical Casimir forces. While approaching the solvent phase separation temperature Ts with ΔT = |Ts - T| decreasing, the length scale of the fluctuations, ξ, increases. An attractive force between two particles separated by a distance d arises when ξ becomes of the same order as d. The value of ξ rises upon approaching the critical point. At the critical point, ξ in theory is infinite.

In the temperature range where critical Casimir forces apply, the nanoparticles thus attract each other, resulting in a controlled aggregate formation.

The aggregation properties differ at different sides of the critical point. For example, in the area on the right-hand side of the critical point in **Fig. 1A****,** solvent density compositional fluctuations mostly consist of the bulk minority solvent component (water); therefore nanoparticle assembly will take place in hydrophilic surroundings. Conversely, on the left-hand side of the critical point, aggregation will take place in 3-methyl pyridine rich (hydrophobic) surroundings. The critical Casimir potential features a higher magnitude on the side of the critical composition such that the solvent density fluctuations are rich in the component preferred by the particles. Therefore, colloids featuring hydrophilic surfaces only slowly aggregate on the left side of the critical composition. Conversely, fast aggregation is observed on the right side. This means that by selecting a concentration at the left-hand side of the critical point or the right-hand side of the critical point aggregation behavior can be regulated.

The nanocrystals at issue in the present invention show a unique behavior in this respect. This is because they have an effective diameter below 20 nm. Their particle size thus is in the same range as the distance d between the particles and the length scale ξ of the fluctuations.

In consequence, the aggregation behavior at a temperature in the aggregation temperature range is the result of a controlled interaction between the particles in a wide temperature range. Aggregation may occur in a temperature region between Ta and Ts with Ta being included and Ts not being included; the value of Ta is set by the length scale of the Casimir potential (and therefore of the solvent density fluctuations) compared to the inter particle distance d and by the magnitude of the Casimir potential. Because of the small size of the nanoparticles investigated in this invention, the condition ξ ~ d may occur at even large ΔT values (tens of degrees).

As indicated above, the semiconductor nanocrystals used in the present invention have an effective diameter of at most 20 nm. Within the context of the present specification the effective particle diameter is the number-average of the length of the longest axis determined in a transmission electron microscopy of a randomly selected sample of 100 particles.

It is noted that the term effective diameter does not necessarily correspond with the actual diameter of the particles. Especially where particles are not spherical, the actual diameter of the particle, or at least one of the diameters of the particles, differs from the effective particle diameter.

It may be preferred for the effective particle diameter to be below 15 nm, in particular below 10 nm. As a minimum, a value of 0.5 nm may be mentioned.

Semiconductor nanocrystals are known in the art. They have luminescent properties. Suitable nanocrystals include nanocrystals comprising Group IV elements (e.g. Silicon, Germanium, Carbon), nanocrystals comprising elements of Group III associated with elements of Group V (e.g. InP, GaP, GaAs, InGaAs, etc.) and nanocrystals comprising elements of Group IIB associated with elements of Group VI (e.g., CdSe, CdTe, CdS, ZnSe, ZnTe, ZnS, etc.). It is within the scope of the skilled person to select suitable nanocrystals.

The invention has been found particularly suitable for cadmium telluride nanoparticles, although is by no means restricted to only CdTe. The general interaction described in this invention can work just as well for any other QD material.

The binary system comprises a first solvent and a second solvent. In the context of the present specification the first solvent is the solvent which has the highest affinity for the semiconductor nanocrystals. This can be determined by dispersing a certain amount of nanocrystals in a binary mixture and bringing the temperature in the hetereogeneous temperature range; the mixture will demix and the nanocrystals will preferentially disperse in the phase with which they have the highest affinity.

Various combinations of first and second solvent can be used in the present invention. The key feature is that they can form a binary system in the presence of semiconductor nanocrystals which is homogenous in one temperature range and heterogeneous in another temperature range. Binary systems are known in the art, and it is within the scope of the skilled person to select a suitable first and second solvent.

In one embodiment, the binary system is a TIS system wherein one of the solvents is an aqueous solvent, that is, water or deuterium oxide ("heavy water"), optionally comprising further components such as soluble salts. This will be discussed in more detail below. A combination of water and deuterium oxide can also be used. Examples of solvents that can be used in combination with an aqueous solvent in a TIS system include C1-C10 alkyl pyridines, e.g., methyl pyridines such as 3-methyl pyridine, 2,6-dimethylpyridine, 2,4-dimethylpyridine, and 2,5-dimethylpyridine, C1-C10 trialkylamines such as triethylamine, and hydrophobic alcohols, including ethylene glycol alkylethers such as ethylene glycol butylether and ethylene glycol pentylether. In another embodiment of the present invention one of the solvents in a TIS system is a non-aqueous polar compound, e.g. a C1-C2 alcohol (methanol or ethanol), or perfluoromethyl cyclohexane, which is combined with a solvent which is an apolar compound such as cyclohexane or C1-C10 alkyl substituted cyclohexane, e.g, methylcyclohexane. Which of the two solvents is the first solvent, for which the particles have the highest affinity, will depend on the nature and surface properties of the particles.

In another embodiment, the binary system is a TDS system. Within this embodiment, one of the solvents, e.g., is selected from the group of alkanes with at least 5 carbon atoms, in particular between 5 and 15, more in particular between 6 and 10, and cycloalkanes with at least 5 carbon atoms, in particular between 6 and 10 carbon atoms. The other solvent in this system can be selected from lower alcohols such as methanol, ethanol, and propanol, aminobenzene, nitrobenzene, and ionic liquids. Combinations which are of particular interest are cyclohexane and methanol, cyclohexane and aminobenzene, hexane and nitrobenzene, and octane and ionic liquid P666Br (trihexyltetradecylphosphonium bromide) or P666Cl (trihexyltetradecylphosphonium bromide). Also in this case the system can contain further components such as soluble salts.

The ratio between the first solvent and the second solvent in not critical to the present invention. In general, the first solvent will make up 10-90 vol.% of the total binary system, in particular 20-80 vol.%.

It has been found that best results are obtained when the solvent composition of the binary system is relatively close to the critical solvent composition. It is preferred for the composition of the system to be such that the percentage of second solvent in the system calculated on the total of first solvent and second solvent is in a range of plus or minus 70% relative to the percentage second solvent on the total of first solvent and second solvent at the critical composition. It may be preferred for the percentage of second solvent on the total of first solvent and second solvent to be in a range of plus or minus 50% relative to the percentage of second solvent on the total of first solvent and second solvent at the critical composition, in particular plus or minus 25%, more in particular plus or minus 15%, especially plus or minus 10%. Of course, as will be evident to the skilled person, the percentages should be selected such that a first and a second solvent are still present in the system in an amount of at least 10 vol.%, calculated on the total of first and second solvent.

As an example, if at the critical composition the percentage of second solvent is 30 vol.% calculated on the total of first and second solvent, and the percentage of second solvent on the total of first solvent and second solvent is in a range of plus or minus 25% relative to the percentage of second solvent on the total of first solvent and second solvent at the critical composition, in the binary system used in the method of the invention the concentration of second solvent is in the range of 22.5-37.5 vol.%.

Within the context of the present specification, the critical composition is the composition where the derivative of the solvent separation temperature as a function of the composition of the binary system is zero. For a TIS system, this generally corresponds to the minimum of the Ts curve. For a TDS system this generally corresponds to the maximum in the Ts curve. The critical composition can be determined by preparing a number of compositions with varying solvent contents and determining Ts for each composition.

The concentration of the nanocrystals in the binary system may vary between wide ranges. In general, there is no lower limit to the concentration of nanocrystals in the binary system. The only counter indication may be that for extremely low concentration values the dynamic light scattering or photoluminescence or absorption signal may be too low for a clear study of the dynamics of the assembly. Additionally, very low concentrations may be less attractive from a commercial point of view. The higher limit in concentration is set by the requirement that nanocrystals should be stable prior to bringing the temperature in the aggregation range; extremely high volume fraction dispersions may be unstable even in the environment of the preferred solvent. Furthermore increasing the concentration of nanocrystals in solution influences the value of Ts and Ta. It is therefore not advisable to increase the concentration over a certain limit if one may want to easily access a wide range of temperature for the assembly (e.g., Ta and Ts may drop well below room temperature). As a general range a nanocrystal concentration of between 0.1 and 100 mg/mL may be mentioned.

The binary system may comprise further components. One component which may be present in the binary system is a dissolved salt, in particular in a TIS system where one of the solvents is an aqueous liquid, but also in a TDS system where one of the solvents is an ionic liquid. The presence of a dissolved salt in this system influences Ts and Ta. More specifically, when a salt is present in the system, both Ts and Ta are expected to decrease. The value of ΔT is expected to increase with the salt concentration.

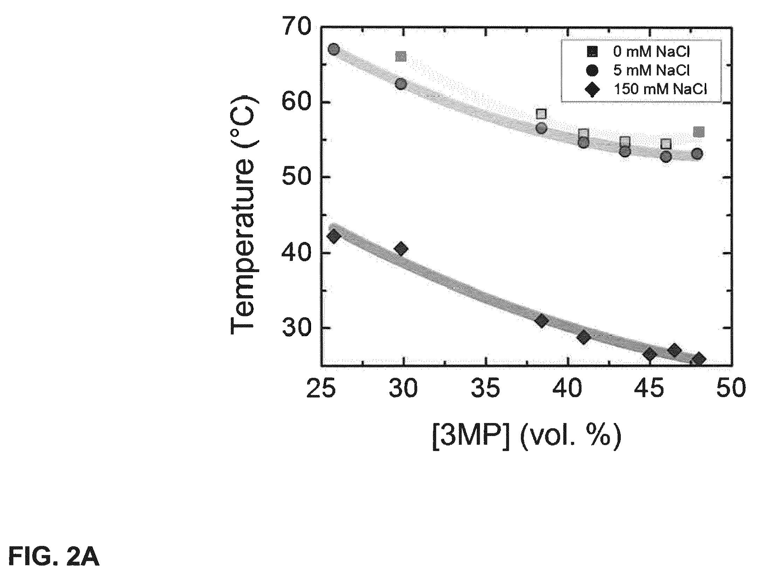

Not wishing to be bound by theory, the underlying mechanism is believed to be as follows. Colloidal semiconductor nanocrystals may be stabilized by the presence of molecular surface groups referred to as ligands. Most ligands are charged, thus provide electrostatic stability of colloidal semiconductor nanocrystals. This may be particularly true for hydrophilic semiconductor nanocrystals. They are charge-stabilized in pure water, exhibiting a Coulombic repulsive potential. The magnitude of the inter-particle electrostatic repulsion may be tuned by adding a soluble salt in solution; this decreases the Debye screening length which sets the minimum average inter quantum dot distance. The Debye screening length can be calculated by methods known in the art. As an example, the Debye screening length of cadmium telluride nanocrystals in a binary mixture of water and 3-methyl pyridine as applied in Example 1 at a salt concentration of 5·10⁻³M is 4nm. By way of illustration, **Fig. 2A** shows a calculation of the Debye screening length as a function of the sodium chloride content of the binary mixture.

If a dissolved salt is used, it is generally present in an amount of 1·10⁻⁵ to 1·10⁻¹ M. It is possible to use the amount of salt in system to ensure that the binary system comprising nanocrystals is stable below Ta. A too high salt concentration may result in aggregation below Ta, an effect which is known as "salting out" in the art. The salt is soluble in water in the amount used. The use of inorganic salts is considered preferred, as organic compounds may interfere with the properties of the final aggregate. Within the group of inorganic salts, the use of soluble alkalimetal or earth alkalimetal halides, nitrates, and sulphates is considered preferred. The use of alkali metal halides, in particular chlorides, may be especially preferred, in view of their high solubility. Sodium chloride and potassium chloride, in particular sodium chloride, are considered preferred.

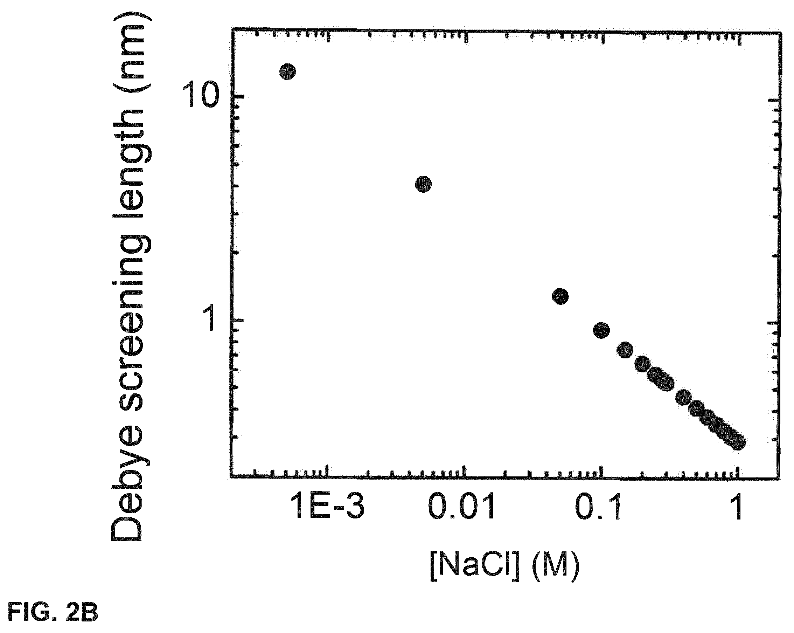

**Fig. 2B** shows a phase diagram for the water/3MP with suspended quantum dots as a function of NaCl salt content. The phase diagram depicts the phase separation line: for temperatures above the line the binary solvent undergoes demixing, while for temperatures below the line the solvent remains well-mixed. As shown in **Fig. 2B****,** the phase diagram is sensitive to the salt content dissolved in the mixture. The minimum of the phase diagram is referred to as the critical point of the mixture. For a given composition, the temperature difference between the phase separation line drawn in the phase diagram and any other temperature is referred to as ΔT (which has a positive for temperatures below the line).

It may be preferred for the binary system according to the invention to consist for at least 90 wt.% of first solvent, second solvent, and nanocrystals, more in particular at least 95 wt.%.

The temperature of the binary system is increased from a value in the homogeneous temperature range to a value in the aggregation temperature range, which is the range between Ta and Ts with Ta being included and Ts not being included, to induce the formation of aggregates of the semiconductor nanocrystals.

The structure of the aggregates is influenced by the selected final temperature, and also by the rate at which the final temperature is obtained. A final temperature which is closer to Ts and a higher rate of temperature increase both increase the aggregation rate. Slow aggregation rates may give rise to more ordered (e.g. polycrystalline, monocrystalline) superstructures; high aggregation rates may give rise to more disordered (e.g. fractal) superstructures.

Poly or monocrystalline superstructures of high quality may form when the final temperature of the binary mixture is relatively close to Ta. It may therefore be preferred for the final temperature of the binary system to be relatively close to Ta, e.g., within 2.0°C of Ta, in particular within 1.5°C of Ta, more in particular within 1.0°C of Ta.

It may also be preferred for the rate of temperature increase to be relatively low, e.g., less than 10°C per hour, in particular less than 5°C per hour, more in particular less than 1°C per hours, e.g., 0.5°C/hour.

It is preferred to keep the system at the temperature between Ta and Ts for a certain period of time. Not only does this ensure that the aggregation is complete, it also improves the homogeneity of the final structure.

It is therefore preferred to keep the temperature of the binary system at a value between Ta and Ts for a period of at least 15 minutes, in particular at least 1 hour, more in particular at least 2 hours, in some embodiments at least 4 hours. As a maximum time, a period of 72 hours may be mentioned.

In one embodiment, a temperature cycle is applied in the method according to the invention, comprising:
- bringing the temperature of the binary system from a value in the homogeneous temperature range to a value in the aggregation temperature range,
- keeping the system at a temperature in the aggregation temperature range for a time sufficient to form an aggregate of semiconductor nanocrystals,
- bringing the temperature of the system to a value within in the homogeneous temperature range,
- keeping the system at a temperature in the homogeneous temperature range for a time sufficient to disaggregate some but not all of the nanocrystals from the aggregate,
- bringing the temperature of the system from a value in the homogeneous temperature range to a value in the aggregation temperature range, and
- keeping the system at a temperature in the aggregation temperature range for a time sufficient to form an aggregate of semiconductor nanocrystals.
The temperature cycle thus applied thus results in an aggregation-disaggregation-aggregation annealing sequence, which results in an aggregate with desirable properties, since the aggregation process is more controlled.

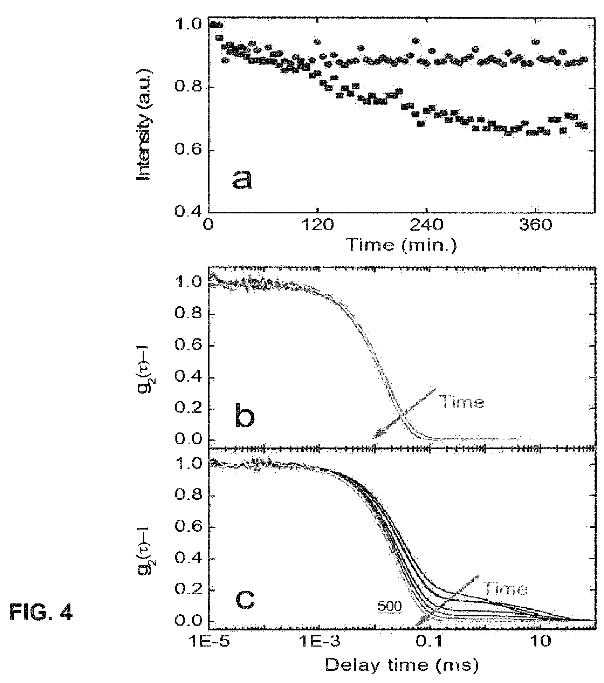

As shown from **Fig. 4a** and **4b** three dimensional aggregates of quantum dots can be achieved having dimensions of anything between the micron and millimeter ranges. Hence, quantum dot aggregates are grown in a controlled way wherein the distance between quantum dots can be controlled by the temperature and/or the ionic concentration of one or more salts, e.g. NaCl, in the solution as explained with reference to **Fig. 2B****.** As will be described hereunder in more detail, the grown quantum dot aggregates form three dimensional superstructures wherein the distance between neighboring quantum dots is smaller than 10 nm such that inter-dot coupling takes place.
In one embodiment, the step of bringing the temperature of the binary system from a value in the homogeneous temperature range to a value in the aggregation temperature range thereby causing formation of an aggregate is carried out in the presence of a substrate.

In their final use, the aggregated nanocrystals are generally in contact with a substrate which functions as a carrier, or which forms a part of the active structure of a device comprising the nanocrystal aggregate. Examples of substrates include carrier materials like glass and quartz, but also materials like glass layers provided with a layer of a transparent conductive oxide, such as indium tin oxide or fluorine doped tin oxide. Carrying out the aggregation step in the presence of a substrate has various advantages. On the one hand it ensures an intimate connection between the aggregate structure and the substrate. On the other hand, when the aggregate is present on a substrate, its handling properties are improved. In other words, it can easily be removed from the system, washed, and dried. This is particularly important if the surface of the substrate shows the same solvent affinity as the nanoparticles, as the growing aggregate will attach, also by the critical Casimir force, to the substrate during assembly.

Where a substrate is present during the aggregation step it is preferred for the aggregation step to be carried out in such a manner that the aggregation of the nanocrystals takes place in close proximity to the substrate. This can be ensured by applying a temperature gradient in the aggregation step, with the temperature of the system near the substrate being between Ta and Ts and the temperature in the system further removed from the substrate being in the homogeneous temperature range. In this way, aggregation will take place near the substrate, promoting deposition of the aggregate on the substrate. Diffusion of the nanocrystals in the system will cause nanocrystals from the region of the system which is in the homogeneous temperature range to the region of the system which is in the aggregation temperature range, therewith promoting further aggregation of the nanocrystals near the substrate, and deposition of the aggregate onto the substrate. The temperature cycle as described above can also be applied in this system.

The aggregate formed is removed from the system. This can be done by methods known in the art. The aggregate will generally be dried to remove the solvent. It may optionally be washed, if so desired. The aggregate can then be processed by methods known in the art. It can, for example, optionally be subjected to annealing or sintering treatments as is known in the art. It is within the scope of the person skilled in the art of semiconductor materials and devices to select suitable methods to apply the aggregate in semiconductor devices.

The present invention also pertains to an aggregate of semiconductor nanocrystals which can be obtained by the method described above.

The aggregate of the present invention is a three-dimensional aggregate of semiconductor nanocrystals with an effective particle diameter of at most 20 nm, the aggregate having a size in all dimensions of at least 5 times the diameter of the nanocrystals, the distance between at least some of the neighboring nanocrystals in the aggregate being at most 10 nm, and the aggregate showing a photoluminescence spectrum which shows a shift to the red as compared to the photoluminescence spectrum of the semiconductor nanocrystals in their unaggregated state.

It is preferred for the distance between at least some of the neighboring nanocrystals to be smaller than 5 nm, more preferably smaller than 2 nm, more in particular below 1 nm, and specifically below 0.5 nm. It is preferred for at least 50%, more in particular at least 70%, still more at least 80%, or even at least 90% or at least 95% of the nanocrystals to be at a distance of their neighboring nanocrystals of at most 10 nm, in particular smaller than 5 nm, more preferably smaller than 2 nm, more in particular below 1 nm, and specifically below 0.5 nm.

It may be preferred for at all three of the dimensions of the three-dimensional aggregate to be at least 100 nm, in particular at least 200 nm. It should be noted that the process of the present invention is suitable for manufacturing aggregates with a relatively large size, e.g., an aggregate wherein at least one of the dimensions is at least 1 micron, in particular at least 10 micron. It is possible with the methods described herein to obtain an aggregate of which the shortest dimension is at least 100 nm, in particular at least 200 nm, in particular at least 1 micron, more in particular at least 10 micron.

For further preferences as regards the size and nature of the nanocrystals reference is made to what is stated above.

The invention also pertains to a substrate provided with a three-dimensional aggregate of semiconductor nanocrystals with an effective particle diameter of at most 20 nm, which aggregate has a size in all dimensions of at least 5 times the diameter of the nanocrystals, the distance between at least some of the neighboring nanocrystals in the aggregate being at most 10 nm, and the aggregate showing a photoluminescence spectrum which shows a shift to the red as compared to the photoluminescence spectrum of the semiconductor nanocrystals in their unaggregated state.

The invention further pertains to a semiconductor device comprising a three-dimensional aggregate of semiconductor nanocrystals with an effective particle diameter of at most 20 nm, which aggregate has a size in all dimensions of at least 5 times the diameter of the nanocrystals, the distance between at least some of the neighboring nanocrystals in the aggregate being at most 10 nm, and the aggregate showing a photoluminescence spectrum which shows a shift to the red as compared to the photoluminescence spectrum of the semiconductor nanocrystals in their unaggregated state, and to the use of a three-dimensional aggregate of semiconductor nanocrystals with an effective particle diameter of at most 20 nm, which aggregate has a size in all dimensions of at least 5 times the diameter of the nanocrystals, the distance between at least some of the neighboring nanocrystals in the aggregate being at most 10 nm, and the aggregate showing a photoluminescence spectrum which shows a shift to the red as compared to the photoluminescence spectrum of the semiconductor nanocrystals in their unaggregated state, in semiconductor devices.

For specific properties of the aggregate reference is made to what is stated above.

The present invention will be elucidated by the following Examples, without being limited thereto or thereby.

### Example 1: aggregation of cadmium telluride nanocrystals in the presence of a substrate

Cadmium telluride nanocrystals were synthesized as described in S. Wu, J. Dou, J. Zhang, S. Zhang, "A simple and economical one-pot method to synthesize high-quality water soluble CdTe QDs", J. Mater. Chem. 22 (29) (2012) 14573, Clapp, Aaron R., Ellen R. Goldman, and Hedi Mattoussi. "Capping of CdSe-ZnS quantum dots with DHLA and subsequent conjugation with proteins." Nature protocols 1.3 (2006): 1258-1266, and Carion, Olivier, et al. "Synthesis, encapsulation, purification and coupling of single quantum dots in phospholipid micelles for their use in cellular and in vivo imaging." Nature protocols 2.10 (2007): 2383-2390.

The nanocrystals were concentrated by repeated centrifugation - redispersion cycles using a centrifugal filter (Millipore). A stock dispersion in water was prepared comprising about 20 mg/mL cadmium telluride nanocrystals capped with thioglycolic acid. The nanocrystals had a particle size of 3 nm.

A binary solution consisting of 3-methylpyridine (3MP) and water was prepared. 3MP was distilled prior to use to guarantee purity. Both 3MP and water were filtered using syringe filters (Millipore) respectively 100 nm (PTFE) and 25 nm (cellulose) pore size. The mixture consisted of 435 microliter 3MP, 516 microliter of filtered nanocrystal stock dispersion, 5 microliter of 1 M NaCl in water and 44 microliter water. The resulting mixture comprised 43.5 vol.% of 3MP and 56.5 vol.% water. The nanocrystal concentration was 10.3 mg/mL.

The percentage of second solvent on the total of first solvent and second solvent at the critical composition of this system was 45.75vol%. The percentage of second solvent used in the system in this example thus is 4.9% relative to the percentage of second solvent on the total of first solvent and second solvent.

The phase separation temperature of the mixture was measured by using a thermostated water bath to be Ts=53.5 °C. The concentration of NaCl may be tuned to adjust the electrostatic interparticle repulsion; it should be noted that increasing NaCl concentration will affect the value of Ts.

The dispersion was placed at room temperature (20°C) in a 7 mL glass vial. On the bottom of this vial a 5 mm x 5 mm clean piece of silicon wafer was placed as substrate. The vial was then submerged in a thermostated water bath (temperature stability was 0.1 °C) at a temperature of T=52.5 °C to induce assembly followed by sedimentation. After 7 hours, the glass vial was removed from the water bath. The substrate was promptly lifted from the bottom of the vial before the temperature of the dispersion decreased. The substrate was placed in a petri-dish and the excess solvent allowed to evaporate for several hours at room temperature.

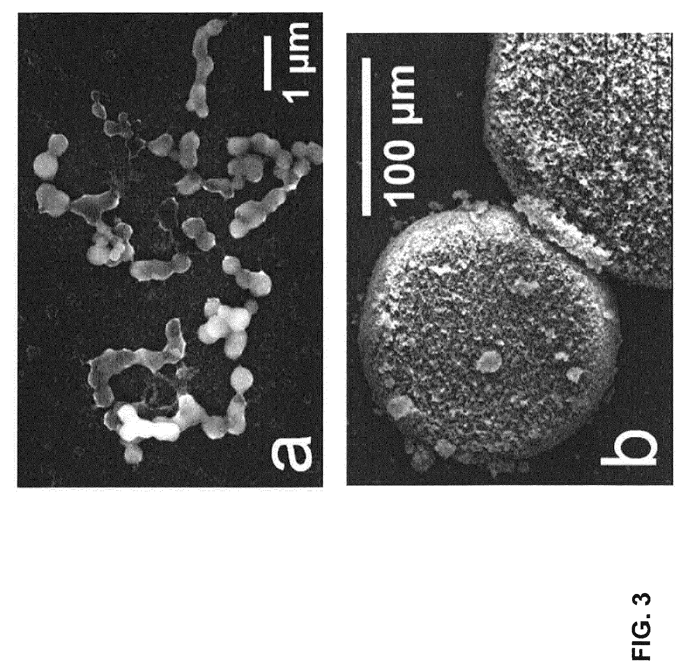

The structures deposited on the substrate were studied by means of Scanning Electron Microscopy (SEM). The results are provided in **Fig. 3****.** As shown in **Fig. 3A** and **3B****,** a clear dependence of the structure of aggregates on the conditions of assembly. These samples were prepared by placing a clean piece of Silicon wafer on the bottom of a vessel and following the procedure described in Example 1. After the assembly of the quantum dot structures had taken place, the piece of Silicon was removed and the excess solvent was dried under ambient conditions. In particular, **Fig. 3A** depicts a SEM picture of liquid-like structures that were grown under conditions of low attractive forces (left side of the critical point, ΔT = 20 °C) and **Fig. 3B** depicts a SEM picture of fractal-like structures that were grown under conditions of high attractive forces (left side of the critical point, ΔT = 1 °C).

### Example 2: aggregation of cadmium telluride nanocrystals, investigation of time-dependent aggregation

The time-dependent growth of nanocrystal aggregates was monitored using Dynamic Light Scattering setup (ALV/CGS-3). The binary system analogous to those of Example 1 were placed in a NMR tube 5 mm in diameter. The tube was flame sealed to avoid evaporation of solvent. The sealed tube was placed inside of the ALV thermostated sample chamber at 52.5 °C. The scattered intensity correlation function was calculated from the measured data every hour. The following systems were studied:
- A composition on the left-hand side of the critical point at a temperature below Ta (20°C below Ts)
- A composition on the left-hand side of the critical point at a temperature between Ta and Ts (1°C below Ts)
- A composition on the right-hand side of the critical point at a temperature below Ta (20°C below Ts)
- A composition on the right-hand side of the critical point at a temperature between Ta and Ts (1°C below Ts)

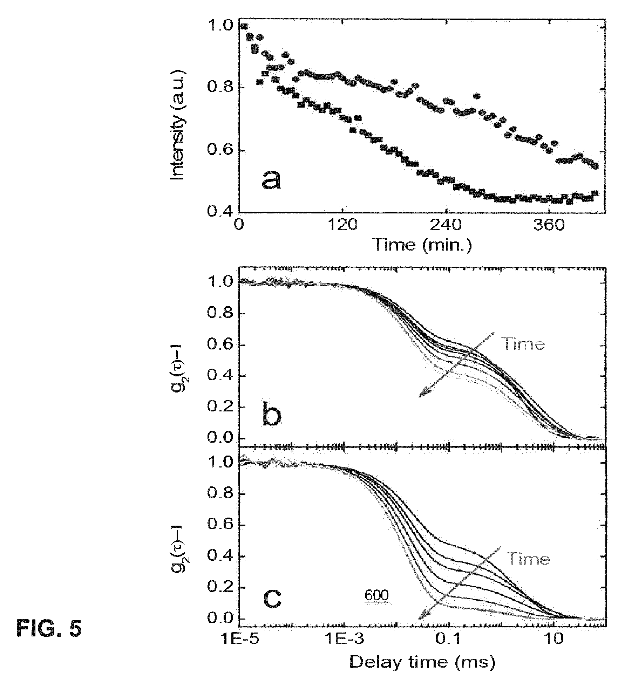

The results are presented in **Fig. 4** and **5****.** In all cases it can be seen that the intensity remains the same over time in the samples below Ta (circles in the **Fig. 4a** and **Fig. 5a**), while the samples between Ta and Ts show a decrease in intensity (squares in the **Fig. 4a** and **Fig. 5a**. This shows that in these samples nanoparticle superstructures are removed from the system.

This is supported by the decay curves, where **Fig. 4b** shows that in the systems below Ta the plot does not change, showing that no aggregation occurs. **Fig. 4c****,** **Fig.5b** and **Fig. 5c** show that in the samples between Ta and Ts a second decay appears at around 10 ms delay time over time. This supports the assembly of aggregates. Note that for the composition shown in Fig.5b, Ta has decreased due to the nanoparticle affinity for the water-rich solvent density fluctuations found on the right side of the critical point.

From the difference between **Fig. 4c** and **Fig. 5c** it can be seen that in the system on the right-hand side of the critical point aggregates faster than the system at the left-hand side of the critical point.

### Example 3: photoluminescence during aggregation

Semiconductor nanocrystals, which are sometimes indicated as quantum dots, find application in many semiconductor devices, including, for example, solar cells, light-emitting diodes (LEDs), photodetectors and are used as photoluminescent labels in biological assays.

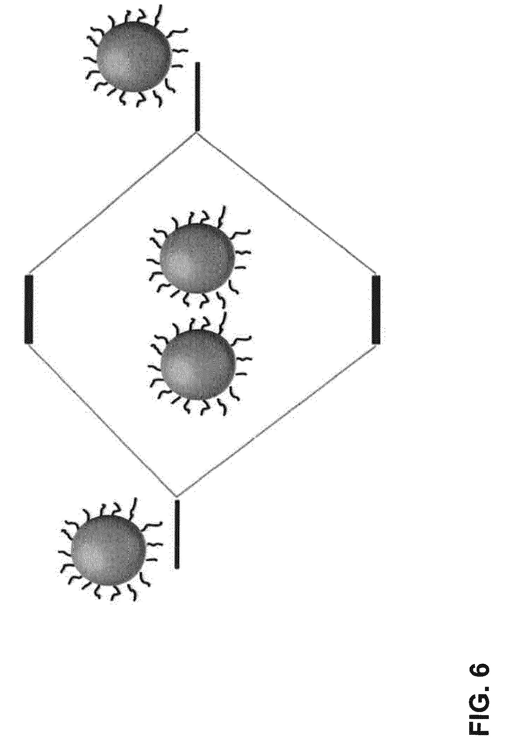

In a device, semiconductor nanoparticles are generally used in the form of an aggregate, also sometimes indicated as superstructure or superlattice, wherein distance between neighboring quantum dots is such that interaction between electronic states is possible. The type of interaction between the semiconductor nanoparticles depends of the surface to surface distance. At shorter distances (typically < 1 nm), the electronic wave-functions confined within the extent of the single nanocrystals may overlap, leading to electronic coupling. This is beneficial for those applications that require an efficient charge transport across the quantum dot superstructure which is important for electronic and optoelectronic application. The electronic coupling between nanocrystals takes place through tunneling of the wave-functions across the energy barrier physically represented by the ligands, or the semiconductor shell (if present), or the solvent. The coupling gives rise to new electronic states belonging to the quantum dot molecule as a whole. This is schematically shown in **Fig. 6****.**

Increasing the number of interacting nanocrystals may give rise to a super band structure. By this term we mean a semi continuous distribution of electronic states which belong to the quantum dot superstructure as a whole. At larger distances (typically between 1 and 10 nm) quantum dots can interact via dipole-dipole coupling, also known as Förster mechanism. This path allows for inter-particle energy transfer, although not for charge transfer since it does not induce the formation of collective energy states. Both of the underlined mechanisms are known to manifest themselves in the photoluminescence spectra as a red shift.

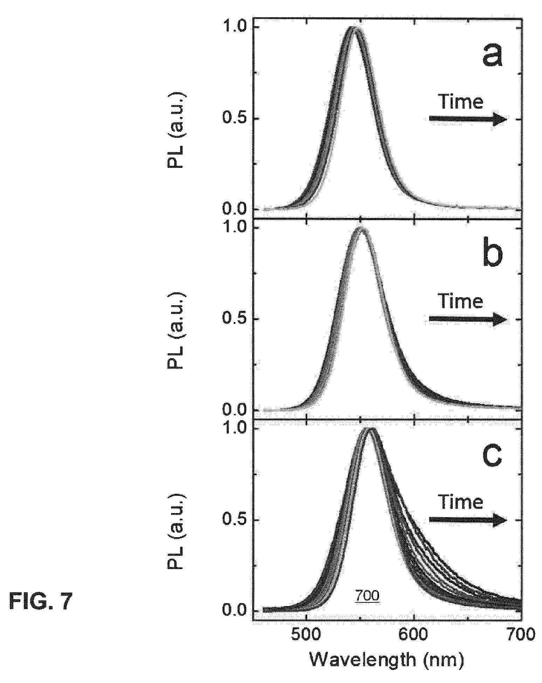

In an experiment that was carried out under the same conditions as Example 1 the optical properties of the semiconductor nanocrystals were monitored during the assembly process by studying the photoluminescence spectra of the colloidal sample. Photoluminescence spectra of nanocrystals dispersed in binary mixtures over time during aggregation are presented for different aggregation conditions (excitation wavelength: 405 nm) in **Fig. 7a-7c**. Every measurement was taken every 40 minutes for 8 hours.

In **Fig. 7a****,** the composition was at the left-hand side of the critical point, and the temperature was well below Ta (20°C below Ts). In **Fig. 7b** the composition was again at the left-hand side of the critical point, and the temperature was 1°C below Ts and thus between Ta and Ts. A comparison between **Fig. 7a** and **7b** shows that in **Fig. 7b** a tail begins to form at the right-hand side of the curve. This is indicative of aggregation taking place. In **Fig. 7c****,** the composition was at the right-hand side of the critical point, and the temperature was 1°C below Ts.

**Fig. 7c** shows photoluminescence (PL) spectra of an identical assembly temperature as **Fig. 7b****,** however the composition of the solvent has been altered to the favorable side of the critical point, thus further increasing the attractive Casimir potential well (see also **Fig. 4c**). **Fig. 7c** shows a net change in the PL spectra with time in the appearance and development of a red emitting tail. The presence of this tail is attributed to the increasing of the inter-dot coupling as the superstructures in the solvents grow with time. Similar PL effects have been found in low-dimensional quantum dot thin films.

Hence, **Fig. 7c** indicates that during the growth of the quantum dot superstructures, neighboring quantum dots are brought within a distance to each other such that inter-dot coupling is established indicating that the solvent-mediated attractive interactions between the nanoparticles result in superstructures wherein the distance between neighboring quantum dot is smaller than 10 nm.

### Example 4: use of a temperature gradient in the aggregation of cadmium telluride nanoparticles onto a substrate

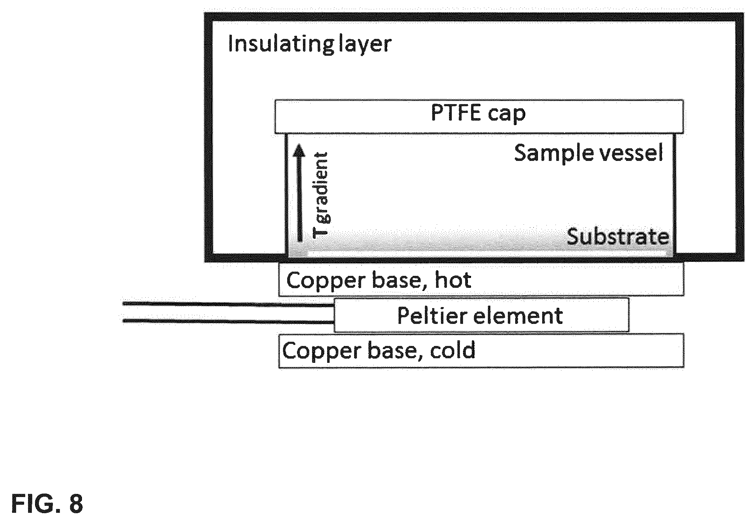

In this example the aggregation of nanocrystals was controlled by the use of a temperature gradient along the gravitational axis. A binary system was prepared as described in Example 1. A clean substrate (in the present case Si, but other materials such as quartz, glass, sapphire, ITO/glass, FTO/glass, etc. are also possible) was placed flat on the bottom of a glass vessel. The dispersion was then added and the vessel sealed with a tight fitting PTFE cap. The glass vessel was placed on top of a flat copper base connected to a Peltier system to control temperature. The vertical walls of the vessel were covered with an insulating layer (i.e. fiber glass) to prevent radial temperature gradients. A schematic representation of the experimental setup is in **Fig. 8****.** The setup induced a temperature gradient along the vertical direction. The temperature value at the bottom of the vessel was measured using a thermocouple embedded in the copper base. Temperature stability was 0.1 °C. The setup was calibrated so as to obtain a temperature of T=52.5 °C at the bottom of the glass vessel, just above the substrate. The temperature gradient ensured that aggregates were formed near the substrate, where the temperature is above Ta, but not in the bulk of the dispersion, where the temperature is below Ta. As nanocrystals diffuse into the heated zone just above the substrate, aggregation starts and the aggregates thus formed assemble on the substrate. A slow aggregation rate was achieved by using a temperature close to the assembly temperature. This resulted in the formation of an aggregate with homogeneous properties. The substrate was removed from the vessel after 7 hours. Altering the assembly temperature greatly affected the rate of deposition and the type of superstructures that could be achieved.

The terminology used herein is for the purpose of describing particular embodiments only and is not intended to be limiting of the invention. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or step plus function elements in the claims below are intended to include any structure, material, or act for performing the function in combination with other claimed elements as specifically claimed. The description of the present invention has been presented for purposes of illustration and description, but is not intended to be exhaustive or limited to the invention in the form disclosed. Many modifications and variations will be apparent to those of ordinary skill in the art without departing from the scope and spirit of the invention. The embodiment was chosen and described in order to best explain the principles of the invention and the practical application, and to enable others of ordinary skill in the art to understand the invention for various embodiments with various modifications as are suited to the particular use contemplated.

## Claims

1. Method for assembling semiconductor nanocrystals comprising:
- providing a binary system comprising semiconductor nanocrystals with an effective particle diameter of at most 20 nm, a first solvent, and a second solvent,
- the system having
* a Ta, which is the aggregation temperature of the system,
* a Ts, which is the solvent separation temperature of the system,
* an aggregation temperature range, which is the range between Ta and Ts with Ta being included and Ts not being included,
* a homogeneous temperature range which is below Ta when Ta is lower than Ts and which is above Ta when Ta is higher than Ts,
* a heterogeneous temperature range which is above Ts when Ta is lower than Ts and below Ts when Ta is higher than Ts, and,
- bringing the temperature of the binary system from a value in the homogeneous temperature range to a value in the aggregation temperature range, thereby causing formation of an aggregate of said semiconductor nanocrystals.

2. Method according to claim 1, wherein the semiconductor nanocrystals have an effective particle diameter below 15 nm, preferably below 10 nm, more preferably below 5 nm.

3. Method according to any one of the preceding claims wherein the composition of the binary system is such that the percentage of second solvent in the system calculated on the total of first solvent and second solvent is in a range of plus or minus 70% relative to the percentage second solvent on the total of first solvent and second solvent at the critical composition, preferably in a range of plus or minus 50%, in particular plus or minus 25%, more in particular plus or minus 15%, especially plus or minus 10%.

4. Method according to any one of the preceding claims, the system having
* a Ta which is below Ts,
* a homogeneous temperature range which is below Ta,
* a heterogeneous temperature range which is above Ts.

5. Method according to any one of claims 1-3, the system having
* a Ta which is above Ts,
* a homogeneous temperature range which is above Ta,
* a heterogeneous temperature range which is below Ts.

6. Method according to claim 4, wherein the first solvent is an aqueous solvent.

7. Method according to any one of the previous claims, wherein the system comprises 1·10⁻⁵ to 1·10⁻¹ M of a dissolved salt, in particular a dissolved inorganic salt.

8. Method according to any one of the preceding claims, wherein the step of bringing the temperature of the binary system from a value in the homogeneous temperature range to a value in the aggregation temperature range thereby causing formation of an aggregate is carried out in the presence of a substrate.

9. Three-dimensional aggregate of semiconductor nanocrystals with an effective particle diameter of at most 20 nm, which aggregate has a size in all dimensions of at least 5 times the diameter of the nanocrystals, the distance between at least some of the neighboring nanocrystals in the aggregate being at most 10 nm, the aggregate showing a photoluminescence spectrum which shows a shift to the red as compared to the photoluminescence spectrum of the semiconductor nanocrystals in their unaggregated state.

10. Three-dimensional aggregate according to claim 9, wherein all three of the dimensions of the three-dimensional aggregate are at least 100 nm, in particular at least 200 nm.

11. Three-dimensional aggregate according to claim 9 or 10, wherein the distance between at least some of the neighboring nanocrystals is smaller than 5 nm, more preferably smaller than 2 nm, more in particular below 1 nm, and specifically below 0.5 nm.

12. Three-dimensional aggregate according to any one of claims 9-11, wherein at least 50%, more in particular at least 70%, still more at least 80%, or even at least 90% or at least 95% of the nanocrystals to be at a distance of their neighboring nanocrystals of at most 10 nm, in particular smaller than 5 nm, more preferably smaller than 2 nm, more in particular below 1 nm, and specifically below 0.5 nm.

13. Substrate provided with a three-dimensional aggregate of any one of claims 9-12.

14. Semiconductor device comprising a three-dimensional aggregate of any one of claims 9-12.

15. Use of a three-dimensional aggregate of any one of claims 9-12 in a semiconductor device.
